# EUROPEAN PATENT SPECIFICATION

(11) **EP 3 886 104 B1**
(45) Date of publication and mention of the grant of the patent: **24.01.2024**
(21) Application number: 20166074.3
(22) Date of filing: 26.03.2020
(51) Int. Cl.: G11C 13/00

(54) **RESISTIVE RANDOM MEMORY ARCHITECTURE WITH HIGH INTEGRATION DENSITY AND CONTROL METHOD THEREOF**
RESISTIVE DIREKTSPEICHERARCHITEKTUR MIT HOHER INTEGRATIONSDICHTE UND STEUERUNGSVERFAHREN DAFÜR
ARCHITECTURE DE MÉMOIRE RÉSISTIVE ALÉATOIRE À HAUTE DENSITÉ D'INTÉGRATION ET SON PROCÉDÉ DE COMMANDE

(43) Date of publication of application: 29.09.2021
(73) Proprietor: Centre National de la Recherche Scientifique, 75016 Paris (FR); Université d'Aix-Marseille, 13007 Marseille (FR); American University Of Beirut, Beirut 1107-2020 (LB)
(72) Inventor: HAJRI, Basma, Beirut 1107 2020 (LB); AZIZA, Hassan, 13013 MARSEILLE (FR); MANSOUR, Mohammad, BEIRUT (LB); CHEHAB, Ali, Beirut 1107 2020 (LB)
(74) Representative: Marchand, André

(56) References cited:
- US-A1- 2013 033 923
- US-A1- 2019 080 753
- CHEN FREDERICK T ET AL: "Write Scheme Allowing Reduced LRS Nonlinearity Requirement in a 3D-RRAM Array With Selector-Less 1TNR Architecture", IEEE ELECTRON DEVICE LETTERS, IEEE, vol. 35, no. 2, 1 February 2014 (2014-02-01), pages 223-225, XP011538108, ISSN: 0741-3106, DOI: 10.1109/LED.2013.2294809 [retrieved on 2014-01-23]

## Description

### TECHNICAL FIELD

The present invention generally relates to resistive random access memories (RRAM) devices.

### BACKGROUND

Recently, resistive random access memories devices received considerable attention in light of their fast programming, low operation voltage, low manufacturing cost, good durability and high scalability.

Memories are everywhere (smartphones, data centers, Internet of Things (IoT), Automotive, Industry, Medical, ...). Beyond mobile applications, the present invention may also translate into better system performance in data centers. In industrial applications, this could translate into more efficient memory use in the design of devices such as smart meters, thermostats, visual or auditory sensory data recognition, bio-informatics.... In this context, RRAM technology is the most promising alternative to traditional non-volatile memory in view of meeting the ever-increasing needs for higher speed, higher precision, lower power and higher integration scale, while maintaining a high quality, low complexity and high reliability.

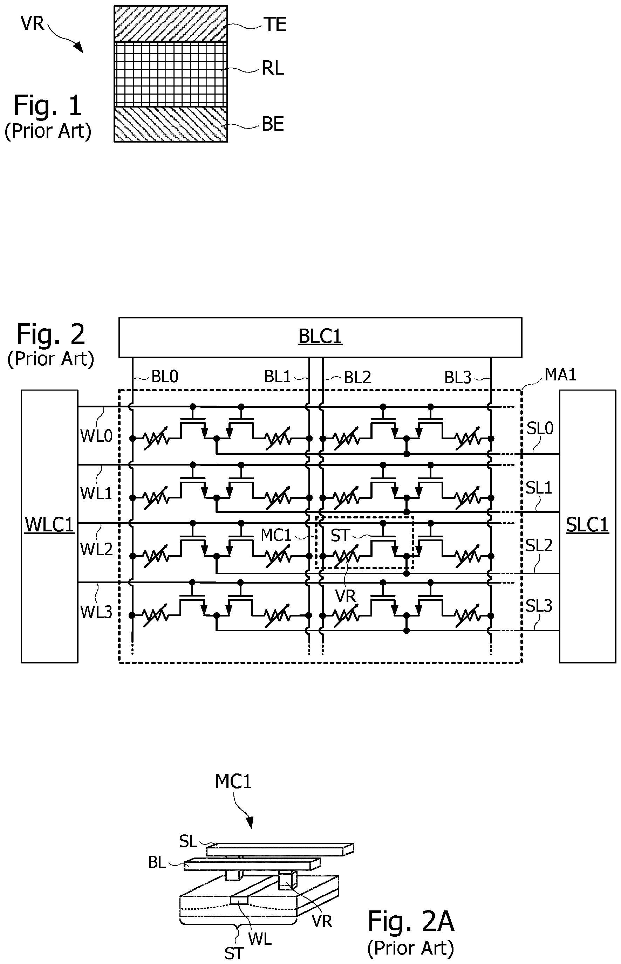

In its simplest form, a resistive or RRAM memory cell relies on a Metal/Insulator/Metal (MIM) stack. As shown in Figure 1, such a MIM stack VR comprises a resistive layer RL having a variable resistance, a top electrode TE and a bottom electrode BE. The resistive layer RL forms a resistive switch between a high resistance state (HRS) and a low resistance state (LRS) that are arbitrarily assigned to logical levels 0 and 1, respectively or conversely.

The resistive memory cells can be unipolar, when switching between the HRS and LRS states is performed by applying voltages or currents of different values, but with the same polarity, or bipolar, when the switching between these states is performed by applying voltages or currents of different values and opposite polarity. In the present disclosure, bipolar devices are considered as these devices are extensively used and studied compared to unipolar devices.

Figure 2 shows an example of a common RRAM memory array architecture. The memory array MA1 of Figure 2 comprises a plurality of memory cells MC1 arranged in rows and columns. Each column comprises a bit line BL0-BL4 controlled by a bit line decoder circuit BLC1. Each row comprises a word line WL0-WL3. controlled by a word line decoder circuit WLC1 and a source line SL0-SL3 controlled by a source line decoder circuit SLC1. Each memory cell MC1 has a commonly used basic RRAM cell structure (1T1R - one transistor, one resistor) comprising a selection transistor ST and the variable resistor VR of Figure 1. The top electrode TE of the resistor VR is connected to a bit line BL. The bottom electrode BE is connected to a drain terminal of the selection transistor ST. A source terminal of the selection transistor ST is connected to a source line SL, and a gate terminal of the selection transistor ST is connected to a word line WL (Figure 2A).

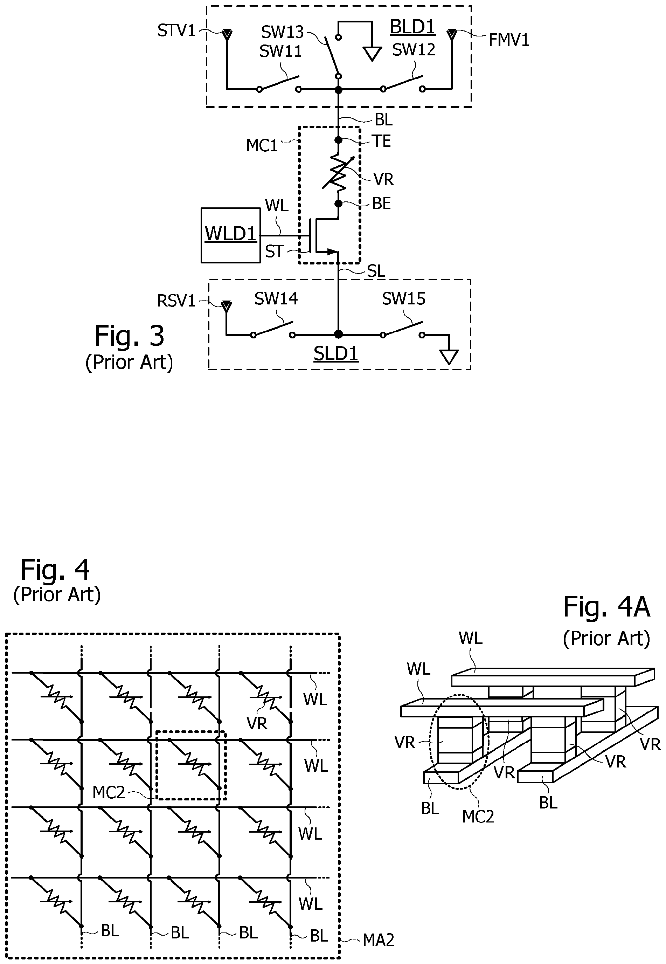

Figure 3 illustrates the control of a conventional 1T1R memory cell MC1. Figure 3 shows one memory cell MC1, a bit line driver circuit BLD1 of the bit line decoder circuit BLC1, connected to the top electrode TE of the variable resistor VR of the memory cell MC1, a word line driver circuit WLD1 of the word line decoder circuit WLC1, connected to the gate of the selection transistor ST, and a source line driver circuit SLD1 connected to the source line decoder circuit SLC1, connected to the source electrode SL of the selection transistor ST. The bit line driver circuit BLD1 comprises three switches SW11, SW12, SW13 forming a selector either to disconnect the top electrode TE of the variable resistor VR or to connect it to a voltage source selected between a set voltage STV1, the ground and a forming voltage FMV1. The word line driver circuit WLD1 is used to control the selection transistor ST. The source line driver circuit SLD1 comprises two switches SW14, SW15 forming a selector either to disconnect the source of the selection transistor ST or to connect it to a voltage source selected between a reset voltage RSV1 or the ground. All the voltages STV1, FMV1, RSV1 are positive voltages.

During set and reset phases, the memory cell MC1 is selected by means of the word line driver circuit WLD1 setting the selection transistor ST in a conducting state. Thus the selected memory cell MC1 is connected to the source line driver circuit SLD1. During the set phase, the bit line driver circuit BLD1 is controlled to connect the top electrode TE of the selected memory cell MC1 to the set voltage source STV1 by closing the switch SW11, and the source line driver circuit SLD1 is controlled to close the switch SW15 to connect the bottom electrode BE of the selected memory cell MC1 to the ground through the selection transistor ST.

During the reset phase, the bit line driver circuit BLD1 is controlled to connect the top electrode TE of the selected memory cell MC1 to the ground by closing the switch SW13 and the source line driver circuit SLD1 is controlled to connect the bottom electrode BE of the selected memory cell MC1 to the reset voltage source RSV1 by closing the switch SW14.

Before a first one of the set and reset operations, the memory cell MC1 is in a "virgin" state and a forming operation is needed to first create a conductive filament within the variable resistor VR. The forming operation requires a high voltage greater than the set and reset voltages, provided by the voltage source FMV1 and applied to the top electrode TE by closing the switch SW12, whereas the bottom electrode BE is connected to the ground by means of the selection transistor ST and the switch SW15. Thus to control the memory cell MC1, three access points are needed: the bit line BL, the source line SL (both used to set and reset the memory cell) and the word line WL to select the memory cell.

One drawback of the 1T1R architecture shown in Figure 2 is related to the area overhead induced by the selection transistor ST in each memory cell MC1, and the requirement of three access points for each memory cell. However, due to the perfect isolation between memory cells provided by the selection transistors ST, the 1T1R architecture is energy efficient and has a shorter access time compared to other alternatives.

Other RRAM memory architectures are disclosed in the patent applications US 2013/033923 and US 2019/080753 and the publication "Write Scheme Allowing Reduced LRS Nonlinearity Requirement in a 3D-RRAM Array With Selector-Less 1TNR Architecture", CHEN Frederick T et al, IEEE Electron Device Letters, vol. 35, no. 2, 1 February 2014 (2014-02-01), pages 223-225.

Figure 4 shows another example of a prior art RRAM memory array architecture, called "crossbar architecture". The memory array MA2 of Figure 4 comprises a plurality of memory cells MC2 arranged in rows and columns and interconnected to each other without selection transistors, thereby maximizing the area efficiency of the memory array MA2. Thus, each memory cell MC2 only comprises a variable resistor VR having a top electrode TE connected to a word line WL, and a bottom electrode BE connected to a bit line BL (figure 4A). By eliminating the selection transistors, the memory cells MC2 in the crossbar architecture achieve the smallest theoretical size of 4F² where F is the minimum feature size (US Patent Publication No. 2016/0064453).

However, the crossbar architecture introduces other challenges as selected memory cells (to be read, set or reset) are no longer isolated from unselected memory cells. Thus, activating a word line and a bit line to access a memory cell will result in sneak path currents, in which current can sneak through other cells, resulting in reading a wrong state of the accessed memory cell. This drawback limits the crossbar memory size. Indeed, in a crossbar, the amount of sneak current ultimately determines the energy efficiency, access time, and area of a memory array in addition to the complexity of the decoding circuitry, especially in case of bipolar devices.

Other structures have been recently presented as a good compromise between the crossbar and the 1T1R architectures, but they still suffer from requiring complex decoding and switching circuitry. For example, U.S. patent Publication No. 2016/0351623 discloses a 1TnR memory array (MA1) architecture dedicated to improve difficulty on recognizing logical 1 and 0 signals by current sensing in high temperature conditions. However, although it reduces the area of the memory array, this architecture presents the same power consumption and the same programming/decoding complexity as the previously published RRAM architectures, such as the 1T1R architecture.

In this context, there is still room for improvement of a RRAM memory array architecture combining high-density with faster response times. Lower power consumption with lower complexity at the same time in the memory array architecture, programming signals and decoding circuitry is still challenging. The present disclosure attempts to solve these problems and others.

### SUMMARY

A memory circuit is described. The memory circuit comprises a first memory word comprising a plurality of variable resistors, each variable resistor forming one memory cell and having a first electrode and a second electrode connected to a bit line control circuit, a first selection transistor comprising a first conduction terminal connected to the first electrode of each variable resistor of the first memory word, a second conduction terminal and a control terminal connected to a word line control circuit, wherein the second conduction terminal of the first selection transistor is connected to a ground of the memory circuit, and each bit line control circuit is configured to set the second electrode of one of the variable resistors either to a high positive voltage to set the corresponding memory cell, to a high negative voltage to reset the corresponding memory cell and to a read voltage to detect whether the corresponding memory cell is set or reset.

According to an embodiment, each bit line control circuit is further configured to set the second electrode of one of the variable resistors (VR) to a forming voltage to set the corresponding memory cell out of a virgin state.

According to an embodiment, the memory further comprises a second selection transistor comprising a first conduction terminal connected to a second memory word formed by another plurality of variable resistors (VR) of the memory circuit, and a second conduction terminal connected to the ground of the memory circuit, and a control terminal connected to the control terminal of the first selection transistor.

According to an embodiment, the memory circuit further comprises a plurality of memory words, arranged in rows and columns, each memory word comprising: a plurality of variable resistors each forming a memory cell of the memory word, and a selection transistor having a first conduction terminal connected to the first electrode of each of the variable resistor of the memory word, a second conduction terminal connected to the ground of the memory circuit, and a control terminal linked to a word line driver circuit by a word line), wherein the control terminal of the selection transistors of all memory words arranged in a same row are connected to a same word line, and all memory words arranged in a same column are connected to a same group of bit lines.

According to an embodiment, the second conduction terminals of the selection transistors of pairs of adjacent rows of memory words are connected to a common ground line of the memory circuit.

According to an embodiment, the memory circuit comprises a voltage generation circuit configured to generate the high positive voltage in the form of a positive pulse signal, and the high negative voltage in the form of a negative pulse signal, the positive and negative pulse signals being provided to the bit line control circuit, the positive pulse signal extending between a ground voltage and the high voltage, and the negative pulse signal extending between the ground voltage and the high negative voltage.

According to an embodiment, the voltage generation circuit comprises: a pulse generator configured to generate the positive pulse signal; and a negative voltage generator receiving the positive pulse signal and configured to generate the negative pulse signal from the positive pulse signal.

According to an embodiment, each of the variable resistors of the memory circuit has a high resistance state when the corresponding memory cell is reset, and a low resistance state when the corresponding memory cell is set, the bit line control circuit being configured to determine whether one of the variable resistors is in the high or low resistance state.

According to an embodiment, to set one of the variable resistors, the bit line control circuit is configured to: supply the high positive voltage to the second electrode of the variable resistor; detect when the variable resistor reaches the low resistance state; and stop supplying the high positive voltage to the second electrode of the variable resistor when the variable resistor is detected in the low resistance state.

According to an embodiment, to reset one of the variable resistors, the bit line control circuit is configured to: supply the high negative voltage to the second electrode of the variable resistor; detect when the variable resistor reaches a high resistance state; and stop supplying the high negative voltage to the second electrode of the variable resistor when the variable resistor is detected in the high resistance state.

According to an embodiment, the bit line control circuit is configured to perform a programming operation of the first memory word, the programming operation comprising: simultaneously resetting all the memory cells of the first memory word; and simultaneously setting selected memory cells of the first memory word.

According to an embodiment, the memory circuit is configured to perform a forming operation comprising: simultaneously setting the selection transistors of the memory circuit in a conducting state to link the first electrode of the variable resistors of the memory circuit to the ground of the memory circuit; and setting the second electrode of the variable resistors to a positive forming voltage. The invention is defined by the features of the independent claim. Preferred embodiments are set out in the dependent claims.

### BRIEF DESCRIPTION OF THE DRAWINGS

The method and/or device may be better understood with reference to the following drawings and description. Non-limiting and non-exhaustive descriptions are described with the following drawings. In the figures, like referenced signs may refer to like parts throughout the different figures unless otherwise specified.
Figure 1 previously described is a cross sectional view of a prior art Metal/Insulator/Metal (MIM) stack forming a variable resistor of a RRAM cell;
Figure 2 previously described is a circuit diagram of a prior art RRAM memory array;
Figure 2A previously described is a perspective schematic view of the structure a memory cell of the RRAM memory array of Figure 2;
Figure 3 previously described is a circuit diagram showing a RRAM memory cell and a prior art circuit for controlling the memory cell;
Figure 4 previously described is a circuit diagram of another prior art RRAM memory array;
Figure 4A previously described is a perspective schematic view of the structure of four memory cells of the RRAM memory array of Figure 3;
Figure 5 is a circuit diagram showing a RRAM memory cell and a circuit for controlling the memory cell, according to an embodiment;
Figure 6 is a circuit diagram of two adjacent memory words of a RRAM word architecture, according to an embodiment;
Figure 6A is a perspective schematic view of the structure of two memory cells of each of the two adjacent memory words of Figure 6;
Figure 7 is a circuit diagram of a RRAM memory architecture, according to an embodiment;
Figure 8 is a layout diagram of a memory array architecture, according to an embodiment;
Figure 9 is a layout diagram of a prior art memory array architecture;
Figure 10 is a circuit diagram of a prior art negative voltage generator;
Figure 11 is a circuit diagram of a circuit for controlling a bit line connected to memory cells in a memory array, according to an embodiment;
Figure 12 shows chronograms of input and output signals of the circuit of Figure 11;
Figure 13 is a circuit diagram of a circuit of Figure 11, according to an exemplary embodiment.

### DETAILED DESCRIPTION

The methods, systems, and apparatuses are set forth in part in the description which follows, and in part will be obvious from the description, or can be learned by practice of the methods, apparatuses, and systems. The advantages of the methods, apparatuses, and systems will be realized and attained by means of the elements and combinations particularly pointed out in the appended claims. It is to be understood that both the foregoing general description and the following detailed description are exemplary and explanatory only and are not restrictive of the methods, apparatuses, and systems, as claimed.

The foregoing and other features and advantages of the invention are apparent from the following detailed description of exemplary embodiments, read in conjunction with the accompanying drawings. The detailed description and drawings are merely illustrative of the invention rather than limiting, the scope of the invention being defined by the appended claims and equivalents thereof.

Embodiments of the invention will now be described with reference to the Figures. The terminology used in the description presented herein is not intended to be interpreted in any limited or restrictive way, simply because it is being utilized in conjunction with detailed description of certain specific embodiments of the invention. Furthermore, embodiments of the invention may include several novel features, no single one of which is solely responsible for its desirable attributes or which is essential to practicing the invention described herein.

The use of the terms "a" and "an" and "the" and similar referents in the context of describing the invention are to be construed to cover both the singular and the plural, unless otherwise indicated herein or clearly contradicted by context. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

Recitation of ranges of values herein are merely intended to serve as a shorthand method of referring individually to each separate value falling within the range, unless otherwise indicated herein, and each separate value is incorporated into the specification as if it were individually recited herein. The word "about," when accompanying a numerical value, is to be construed as indicating a deviation of up to and inclusive of 10% from the stated numerical value. The use of any and all examples, or exemplary language ("e.g." or "such as") provided herein, is intended merely to better illuminate the invention and does not pose a limitation on the scope of the invention unless otherwise claimed. No language in the specification should be construed as indicating any non-claimed element as essential to the practice of the invention.

References to "one embodiment," "an embodiment," "example embodiment," "various embodiments," etc., may indicate that the embodiment(s) of the invention so described may include a particular feature, structure, or characteristic, but not every embodiment necessarily includes the particular feature, structure, or characteristic. Further, repeated use of the phrase "in one embodiment," or "in an exemplary embodiment," do not necessarily refer to the same embodiment, although they may.

As used herein the term "method" refers to manners, means, techniques and procedures for accomplishing a given task including, but not limited to, those manners, means, techniques and procedures either known to, or readily developed from known manners, means, techniques and procedures.

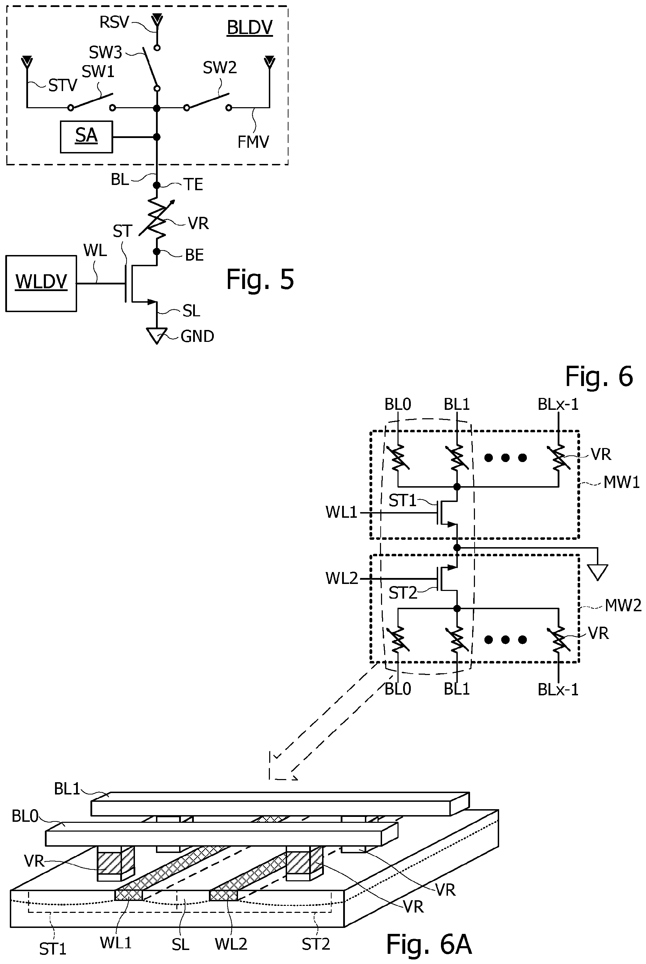

Figure 5 illustrates a control circuit of a RRAM memory cell according to an embodiment. The memory cell comprises a variable resistor VR. The control circuit of Figure 5 comprises a bit line driver circuit BLDV connected to the top electrode TE of the variable resistor VR, and a word line driver circuit WLDV connected to the gate of the selection transistor ST. It may be observed that the control circuit does not comprise any source line driver circuit, the source terminal of the selection transistor ST being connected to the ground. The bit line driver circuit BLDV comprises three switches SW1, SW2, SW3 forming a selector either to disconnect the top electrode TE of the variable resistor VR or to connect it to a voltage source selected between sources providing a set voltage STV, a reset voltage RSV and a forming voltage FMV. The word line driver circuit WLDV provides suitable voltages to control the conductive state of the selection transistor ST. Voltages STV and FMV are positive, and voltage RSV is negative.

During set and reset phases, the memory cell is selected by means of the word line driver circuit WLDV setting the selection transistor ST in its conducting state and thus linking the bottom electrode BE of the variable resistor to the ground. During the set phase, the bit line driver BLDV is controlled to provide the set voltage STV to the top electrode TE of the variable resistor VR by closing the switch SW1. The set voltage STV sets the variable resistor VR to its low resistance state (LRS). During the reset phase, the top electrode TE of the variable resistor VR is supplied with the reset voltage RSV by closing the switch SW3. The reset voltage RSV sets the variable resistor VR to its high resistance state (HRS). The correspondence between the states LRS and HRS of the variable resistor and respectively the states 0 and 1 of the bit stored by the memory cell is arbitrarily chosen.

Before a first one of the set and reset operations, the voltage resistor VR is in a "virgin" state and a forming operation is needed to first create a conductive filament within the variable resistor VR, which sets the variable resistor to its low resistance state. The forming operation requires a high voltage FMV greater than the set and reset voltages STV, RSV to be applied to the top electrode TE by closing the switch SW2, whereas the bottom electrode BE is linked to the ground through the selection transistor ST. Thus to control the memory cell, only two access points are needed: the bit line BL, and the word line WL to select the memory cell.

A read operation is performed by selectively activating a sense amplifier SA in the bit line driver circuit BLDV connected to the bit line BL of the memory cell to read. The sense amplifier SA provides a current in or voltage to the bit line BL connected to a memory cell to read selected by a word line WL setting the corresponding selection transistor in its conducting state. The sense amplifier is configured to read a current intensity or a voltage which depends on the resistance, high or low, of the corresponding selected memory cells to be read, or compare this current intensity or voltage with threshold values to determine whether the memory cell is in the high or low resistance state.

According to an embodiment, based on the specific control method using the circuit of Figure 5, the memory cells of the resistive memory array are grouped together to form memory words where all memory cells share a same selection transistor. In addition, the memory words connected to a same word line are also linked to a common grounded source line through respective selection transistors.

Figures 6 and 6A illustrate a RRAM word architecture, according to an embodiment. Figure 6 show two memory words MW1, MW2 of x bits, that are controlled according to the circuit of Figure 5 using the bit line driver circuit BLDV and the word line driver circuit WLDV. Each memory word MW1, MW2 comprises x variable resistors VR and a single selection transistor ST1, ST2. The top electrodes TE of the x variable resistors VR of each memory word MW1, MW2 are connected respectively to bit lines BL0, BL2, ... BLx-1. The bottom electrodes BE of the x variable resistors of each memory word MW1, MW2 are connected to the drain of the selection transistor ST1 or ST2. The gate of each selection transistor ST1, ST2 is connected to a respective word line WL1, WL2. The sources of the selection transistors ST1, ST2 are connected to the ground, for example to a common ground line. Thus each selection transistor ST1, ST2 is used to select all memory cells forming one memory word MW1 or MW2, the bit lines BL0-BLx-1 being set to suitable voltages depending to the operation, set or reset, to be performed.

In Figure 6A, only the bit lines BL0, BL1 and four memory cells are shown. The word lines WL1, WL2 are formed by the gates of the selection transistors ST1, ST2. The transistors ST1, ST2 share a same source doped region SL. The variable resistors VR can be formed above the drain doped regions of the transistors ST1, ST2. Each of the transistors ST1, ST2 has a width defined by the number x of memory cells in each of the memory words MW1, MW2 and the current to be transmitted through the variable resistors of the x memory cells when all the x variable resistors of the memory word have to be set to the LRS or HRS state.

Thus, the memory word architecture of Figure 6, 6A requires a single selection transistor ST1, ST2 for each memory word MW1, MW2, and no source line driver is needed, leading to a memory architecture with a memory array and decoding and control circuitry having a reduced complexity. This memory architecture combines the advantages of the crossbar architecture in terms of density and those of the 1T1R architecture in terms of performance.

In addition, all voltages are applied directly from the top electrode TE of the memory cells without having to pass through a transistor (i.e. the selection transistor ST1, ST2), in contrast with the above disclosed prior art architectures requiring high voltage selection transistors ST.

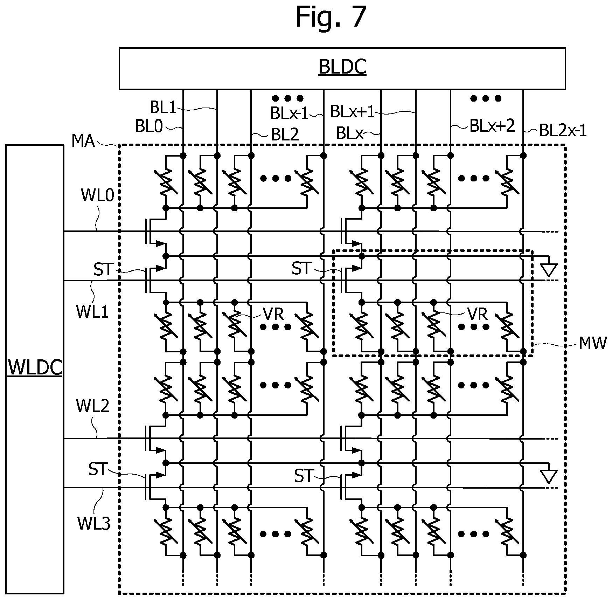

Figure 7 illustrates a RRAM memory architecture, according to an embodiment. Figure 7 shows a memory array MA comprising a plurality of memory words MW arranged in rows and columns. More particularly, Figure 7 shows two columns and four rows of x-bit memory words. Each memory word MW has the architecture disclosed in Figure 6, with x variable resistors VR and a single selection transistor ST. The drain of each transistor ST is connected to the bottom electrodes of the variable resistors of the memory word, the source of each transistor ST is connected to a ground line and the gate of each transistor ST is connected to one of the word line WL0, WL1, WL2, WL3. All memory words of a same row are connected to a same word line, and all memory words of a same column are connected to a same group of bit lines BL0 - BLx-1, BLx - BL2x-1. All the bit lines BL0 - BL2x-1 are connected to a bit line decoding circuit BLDC. All the word lines WL0 - WL3 are connected to a word line decoding circuit WLDC. No source line driver or additional contacts (excepting ground) are needed at the array level. Moreover, since each selection transistor ST is used to select only one memory word, it is shared between the x memory cells forming the word, which are connected to different bit lines (e.g. BL0-BLx-1). This induces a valuable memory chip area reduction. The bit line decoding circuit BLDC can comprise an address decoding circuit and x bit decoding driver circuits such as the circuit BLDV, to select a memory word column to be connected respectively to the x bit decoding driver circuits. The word line decoding circuit WLDC comprises an address decoder and the word line driver circuit WLDV to select one of the word line WL0-WL3 to be supplied with the suitable voltage for setting the selection transistors connected to the selected word line to their conducting state.

In the example of Figure 7, the selection transistors ST of each pair of adjacent rows share a same ground line connected to the sources of the selection transistors.

Finally, the architecture of Figures 6 and 7 results from:
1. a new control method applying either positive or negative voltages to the top electrode of the memory cell;
2. sharing of a unique selection transistor ST between different memory cells belonging to a same memory word, the source of the selection transistor being connected to ground, thus eliminating the need for a source line decoder in the memory array MA, reducing the memory area and increasing the array integration.

Compared with the prior art resistive memory array architectures, the memory array architecture of Figure 7 has a drastically reduced complexity. In addition, the memory array architecture of Figure 7 does not require complex addressing and control routing circuitry since in the control method the set, reset and forming operations are performed from the top electrode while the bottom electrode remains grounded. This eliminates the need for expensive controllers and/or complex memory management. The memory array architecture of Figure 7 maximizes the RRAM density, minimizes the leakage path current and reduces the complexity of the array peripheral circuits, as presented in Table I below.

**Table I**

| Architecture | RRAM Density | Leakage Current | Array complexity |
|---|---|---|---|
| MA1 (Figure 2) | Low | zero | High |
| MA2 (Figure 4) | High | High | Low |
| MA (Figure 7) | High | Low | Low |

According to table I, the density of the the memory array MA (Figure 7) is increased since it uses a single selection transistor shared by all memory cells of each memory word and having a grounded source shared by two adjacent rows of memory words. The number of switches required in the memory array MA is reduced to only three switches per memory cell (as shown in Figure 5),whereas five switches are needed in the 1T1R architecture (as shown in Figure 3). In addition, the number of contacts on the source region can be reduced, with respect to the contacts required on the source regions of the 1T1R architecture. The leakage current remains low in the architecture of Figure 7 due to the presence of the selection transistors, similar to the 1T1R architecture. With regard to complexity, the need for a source line driver is eliminated in the memory architecture of Figure 7 since all the selection transistor sources are grounded.

According to an embodiment, programming one word MW1, MW2, MW in the memory is performed in two steps, the corresponding selection ST1, ST2 transistor being set in its conductive state. In a first step, the bit line driver circuit BLDV is controlled to provide the reset voltage RSV simultaneously to all the memory cells of the word to set them in the high resistance state HRS. In a second step, the bit line driver circuit BLDV is controlled to provide the set voltage STV only to the memory cells to be set in the low resistance state LRS. In another embodiment, all the memory cells of the word MW1, MW2, MW to program are simultaneously set in LRS state in the first step, and in the second step, only the memory cells of the word to be set in HRS state receive the reset voltage RSV.

According to another embodiment, programming one word MW1, MW2, MW in the memory is performed in a single step, the corresponding selection ST1, ST2 transistor being set in its conductive state, by controlling the bit line driver circuit BLDV to selectively provide the reset voltage RSV to the memory cells of the word to be set in the high resistance state HRS and provide the set voltage STV to the memory cells of the word to be set in the low resistance state LRS.

According to an embodiment, the bit line and word line decoder circuits WLDC and BLDC are configured to:
- provide the forming voltage FMV simultaneously to all the variable resistors VR of the memory array MA in a virgin state, which sets all the variable resistors to a low resistance state, and
- then provide the reset voltage RSV to simultaneously to all the variable resistors VR of the memory array MA to set the variable resistors to their HRS state.

It can be observed that the resistance of the variable resistors VR after the forming operation can be different from the resistance in the LRS state.

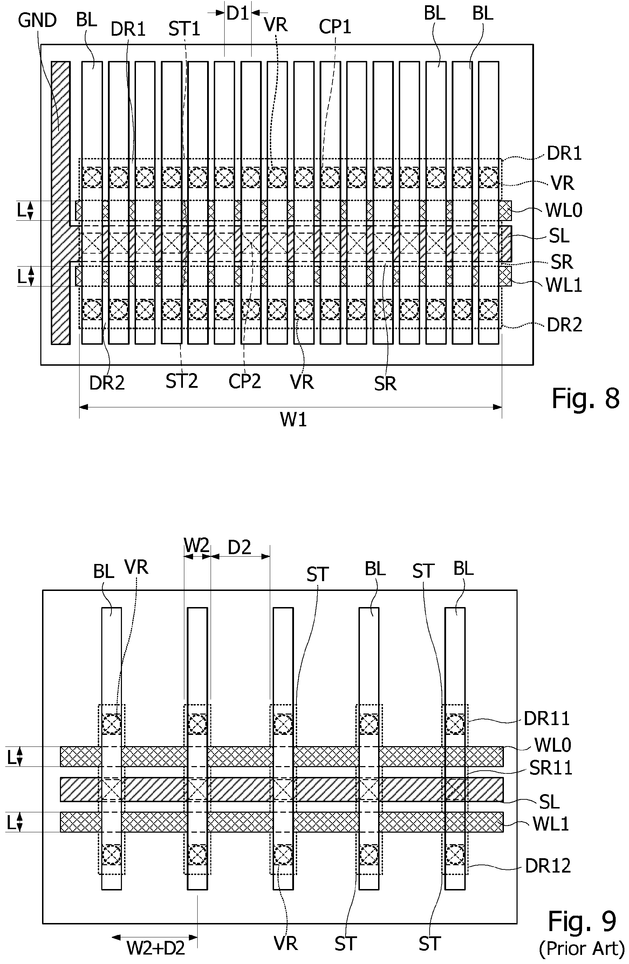

A fully functional memory based on the memory architecture of figure 7 can be manufactured on a silicon wafer. Figure 8 shows a layout of the memory words MW1, MW2 (Figure 6) as formed on a silicon substrate. The layout comprises two gate lines WL0, WL1 forming the gates of the selection transistors ST1, ST2. The gate lines WL0, WL1 divide an active layer of the substrate into active regions that are doped to form the two respective drain regions DR1 DR2 and one shared source region SR of the transistors ST1, ST2. On each drain region DR1, DR2, contact pads CP1 are formed to connect the drain regions DR1, DR2 to the bottom electrodes of variable resistors VR. The source region SR also comprises contact pads CP2 to connect the common source region SR to the source line SL formed on the substrate above the source region SR. The source line SL is connected to the ground GND. Bit lines BL disposed perpendicularly from the gate lines WL0, WL1 interconnect the top electrodes of two respective variable resistors VR. The selection transistors ST1, ST2 have a width W1 corresponding to the length of one of the drain regions DR1, DR2, and a length L corresponding to the width of the gate line WL01 or WL1.

The width W1 of the transistors ST1, ST2 is defined according to a considered manufacture technology, and the number x (=16 is the example of Figure 8) of the memory cells in each memory words. In the HCMOS9 130 nm technology of STMicroelectronics^{®}, the width W1 can be set to about 3.84 µm.

Figure 9 shows a conventional layout comprising separate selection transistors ST for each bit line BL (1T1R architecture of Figure 2). The layout of Figure 9 comprises two gate lines WL0, WL1 forming the gates of two rows of selection transistors ST, and one bit line BL formed above one pair of selection transistors ST. Each pair of selection transistor ST comprises a common source region SR11 between the two gate lines WL0, WL1 and two respective drain regions DR11, DR12. Each source and drain region comprises a contact pad, the contact pad of each drain region DR11, DR12 being connected with the bottom electrode of a respective variable resistor VR, the top electrode of each variable resistor being connected to a bit line BL. For electric insulation reasons, the active regions DR11, DR12, SR11 of each selection transistor ST must be spaced from active regions of the adjacent selection transistors by a sufficient distance, to prevent current leakage between the active regions of adjacent transistors. In the HCMOS9 130 nm technology, this distance (D2 in Figure 9) is at least equal to 0.54 µm. In this technology, the transistors ST have a width W2 at least equal to 0.24 µm. Therefore the spacing of the bit lines BL (or variable resistors VR connected to two adjacent bit lines) is at least equal to W2+D2 = 0.78 µm in the layout of Figure 9. In the layout of Figure 8, the corresponding spacing D1 of the bit lines BL (or variable resistors VR connected to two adjacent bit lines) may be estimated by dividing the width W1 of one selection tranistor ST by the number x of bits per memory word: D1 ≈ W1/x = 3.84/16 = 0.24. Thus the memory cell density of the architecture of Figures 7, 8 is increased by a ratio of about 70% ((W2+D2-D1)/(W2+D2)) when compared with the 1T1R architecture of Figures 2, 9.

After simulation and design of fabrication masks of the different architectures using a HCMOS9 130 nm technology, Table II below shows the total memory area of the proposed architecture of Figures 7, 8 compared to the 1T1R architecture of Figures 2, 9, with and without decoders and negative voltage generators (NVG). The total area estimation has been done considering only the transistors area since, most commonly, the variable resistors VR are placed in the back-end of the line (i.e. in one metal layer above the transistors).

**Table II**

| Architecture | Area |
|---|---|
| 1T1R 16-bit memory word | 42.198 µm² |
| 1T1R 16x16 memory array | 675.168 µm² |
| 16-bit memory word (Fig. 6) | 9.494 µm² |
| 16x16 memory array (Fig. 7) | 151.904 µm² |
| 1T1 R 256Mb memory array | 675.168 mm² |
| 256Mb memory array (Fig. 7) | 7936.3 mm² |
| 1T1R 256Mb memory array with NVG and decoders | 11838.76 mm² |
| 256Mb memory array (Fig. 7) with NVG and decoders | 7936.3 mm² |

The total area improvement for a 256Mb memory without NVG and without decoders is 77.5%. The total area improvement for a 256Mb memory with NVG and decoders is 33%.

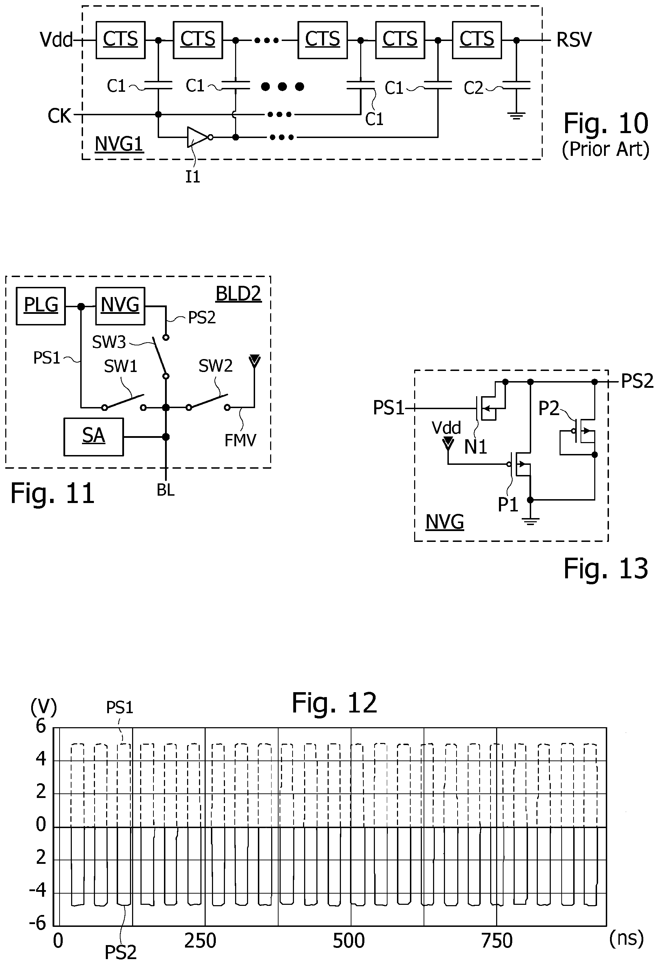

Figure 10 shows an example of a negative voltage generator NVG1 comprising a traditional DC-DC converter using switched capacitors CTS. The voltage generator NVG1 comprises a plurality of stages connected in series. Each stage comprises two charge transfer switches CTS connected in series, the outputs of the two charge transfer switches CTS receiving through a respective capacitor C1 respectively a clock signal CK and the clock signal CK inverted by an inverter I1. The output of second charge transfer switch CTS of each stage is connected to the input of the first charge transfer switch CTS of the next stage. The first charge transfer switch CTS of the first stage receives the supply voltage Vdd of the circuit. The voltage generator NVG1 further comprises a last stage comprising a charge transfer switch CTS, the output of which forming the output of the circuit NVG1 providing the negative reset voltage RSV and being linked to the ground through a capacitor C2. The circuit NVG1 operates as a charge pump. The charge transfer switches CTS can be implemented using only NMOS (N-channel Metal Oxide Semiconductor) and PMOS (P-channel Metal Oxide Semiconductor) transistors. However the capacitors C1, C2 are bulky components and represent significant limitations in terms of substrate area. The capacitors C1, C2 can be replaced by inductors. However such inductors are more bulky than capacitors.

Figure 11 shows a bit line driver circuit BLD2, according to an embodiment. The bit line driver circuit BLD2 differs from the circuit BLDV (Figure 5) in that the set voltage STV is provided by a pulse generator PLG in the form of a positive pulse signal PS1 and the reset voltage RSV is provided in the form of a negative pulse signal PS2 by a negative voltage generator NVG receiving the pulse signal PS1 from the pulse generator PLG. The generator PLG provides the pulsed signal PS1 to one of the bit lines BL through the switch SW1. The generator NVG provides the negative pulsed signal PS2 to the bit line BL through the switch SW3.

Figure 12 shows chronograms of examples of the pulsed signal PS1 provided by the pulse generator PLG and the pulse signal PS2 provided by the negative voltage generator NVG. In the example of Figure 11, the signal PS1 comprises pulses extending between peak values of about 0 V and 5V and having a period of about 40 ns. The signal PS2 comprises pulses having substantially the same period and extending between peak values of about 0 V and -5 V.

According to an embodiment, a memory cell MC is set by providing the pulse signal PS1 to the bit line BL through the switch SW1 which is closed until the low resistance (LRS) is reached. The memory cell can be detected in the LRS state when the sense amplifier SA detects a current in the bit line BL higher than a reference current intensity. Then the pulse generator PLG is stopped and/or the switch SW1 is open. To reset a memory cell MC, the circuit NVG receiving the pulse signal PS1 provides the negative pulse signal PS2 to the bit line BL through the switch SW3 which is closed until the high resistance state (HRS) is reached. The memory cell can be detected in the HRS state when the sense amplifier SA detects a current in the bit line BL lower than the reference current intensity. Then the pulse generator PLG is stopped and/or the switch SW3 is open. This memory cell programming method enables power saving and limits aging of the memory.

According to another embodiment, the detection of the LRS or HRS states by the sense amplifier SA can be omitted, and replaced by activating a pulse counter or a timer opening the switches SW1, SW3 after a given time has elapsed or a given number of pulses are counted.

Figure 13 shows an embodiment of the circuit NVG. The circuit NVG comprises one transistor NMOS N1 and two transistors PMOS P1, P2. The pulse signal PS1 received by the circuit NVG is applied to the gate of the transistor N1. The drain and source of the transistor N1 are connected to the drains of the transistors P1 and P2 and to the output of the circuit NVG providing the pulse signal PS2. The gate of the transistor P1 receives the supply voltage Vdd of the circuit. The sources of the transistors P1 and P2 and the gate of the transistor P2 are connected to the ground. The transistor N1 is connected as a capacitor, the transistor P1 is connected as a resistor and the transistor P2 is connected as a diode. The circuit NVG clamps the input signal PS1 to a different dc voltage level. The size of the transistors N1 and P1 determine the values R, C of the resistor and the capacitor which define a time constant of the circuit NVG (= R.C). This time constant can be large enough to ensure that the capacitor (N1) does significantly not discharge during the time interval when the diode (P2) is in a non-conducting state.

According to an example, each variable resistor VR can comprise layers of titanium nitride (TiN) forming the bottom and top electrodes BE, TE, and a resistive layer RL comprising a dielectric layer for example in hafnium oxide (HfO₂), and a conductive layer for example in titanium (Ti).

In some embodiments, some or all of the functions or process(es) described herein and performed by a software program that is formed from computer readable program code and that is embodied in a computer readable medium. The phrase "computer readable program code" includes any type of computer code, including source code, object code, executable code, firmware, software, etc. The phrase "computer readable medium" includes any type of medium capable of being accessed by a computer, such as read only memory (ROM), random access memory (RAM), or any other type of memory.

While the invention has been described in connection with various embodiments, it will be understood that the invention may be subjected to further modifications. This application is intended to cover any variations, uses or adaptations of the invention following, in general, the principles of the invention, and including such departures from the present disclosure as, within the known and customary practice within the art to which the invention pertains.

In this respect, it is not necessary that the memory cells of two adjacent word lines WL of the memory array MA share a same source line connected to the ground. In contrast, each word line of the memory array MA can have its own source line connected to the ground, even if this leads to a lower memory density.

## Claims

1. A memory circuit comprising a first memory word (MW) comprising:
a plurality of variable resistors, each variable resistor (VR) forming one memory cell and having a first electrode (BE) and a second electrode (TE) connected to a bit line control circuit (BLDV); and
a first selection transistor (ST, ST1) comprising a first conduction terminal connected to the first electrode (BE) of each variable resistor of the first memory word, a second conduction terminal (SL) and a control terminal connected to a word line control circuit (WLDV),
wherein:
the second conduction terminal (SL) of the first selection transistor (ST, ST1) is connected to a ground of the memory circuit, and
each bit line control circuit is configured to set the second electrode (TE) of one of the variable resistors to a high positive voltage (STV) to set the corresponding memory cell, to a high negative voltage (RSV) to reset the corresponding memory cell and to a read voltage to detect whether the corresponding memory cell is set or reset.

2. The memory circuit of claim 1, wherein each bit line control circuit (BLDV) is further configured to set the second electrode (TE) of one of the variable resistors (VR) to a forming voltage to set the corresponding memory cell out of a virgin state.

3. The memory circuit of claim 1 or 2, comprising a second selection transistor (ST2) comprising a first conduction terminal connected to a second memory word (MW2) formed by another plurality of variable resistors (VR) of the memory circuit, and a second conduction terminal connected to the ground of the memory circuit, and a control terminal connected to the control terminal of the first selection transistor (ST1).

4. The memory circuit of one of claims 1 to 3, comprising a plurality of memory words (MW), arranged in rows and columns, each memory word comprising:
a plurality of variable resistors (VR) each forming a memory cell of the memory word, and
a selection transistor (ST) having a first conduction terminal connected to the first electrode (BE) of each of the variable resistor of the memory word, a second conduction terminal connected to the ground of the memory circuit, and a control terminal linked to a word line driver circuit (WLDC) by a word line (WL0-WL3)),
wherein the control terminals of the selection transistors of all memory words arranged in a same row are connected to a same word line (WL0-WL3), and all memory words arranged in a same column are connected to a same group of bit lines ((BL0 - BLx-1, BLx - BL2x-1).

5. The memory circuit of claim 4, wherein the second conduction terminals of the selection transistors (ST) of pairs of adjacent rows of memory words are connected to a common ground line (SL) of the memory circuit.

6. The memory circuit of claim 1 to 5, comprising a voltage generation circuit configured to generate the high positive voltage (STV) in the form of a positive pulse signal (PS1), and the high negative voltage (RSV) in the form of a negative pulse signal (PS2), the positive and negative pulse signals being provided to the bit line control circuit (BLDV), the positive pulse signal extending between a ground voltage and the high voltage (STV), and the negative pulse signal extending between the ground voltage and the high negative voltage (RSV).

7. The memory circuit of claim 6, wherein the voltage generation circuit comprises:
a pulse generator (PLG) configured to generate the positive pulse signal (PS1); and
a negative voltage generator (NVG) receiving the positive pulse signal and configured to generate the negative pulse signal (PS2) from the positive pulse signal.

8. The memory circuit of claim 1 to 7, wherein each of the variable resistors (VR) of the memory circuit has a high resistance state when the corresponding memory cell is reset, and a low resistance state when the corresponding memory cell is set, the bit line control circuit (BLDV) being configured to determine whether one of the variable resistors (VR) is in the high or low resistance state.

9. The memory circuit of claim 8, wherein, to set one of the variable resistors (VR), the bit line control circuit (BLDV) is configured to:
supply the high positive voltage (STV) to the second electrode (TE) of the variable resistor;
detect when the variable resistor reaches the low resistance state; and
stop supplying the high positive voltage to the second electrode (TE) of the variable resistor when the variable resistor is detected in the low resistance state.

10. The memory circuit of claim 8 or 9, wherein, to reset one of the variable resistors (VR), the bit line control circuit (BLDV) is configured to:
supply the high negative voltage (RSV) to the second electrode (TE) of the variable resistor;
detect when the variable resistor reaches a high resistance state; and
stop supplying the high negative voltage to the second electrode of the variable resistor when the variable resistor is detected in the high resistance state.

11. The memory circuit of one of claims 1 to 10, wherein the bit line control circuit (BLDV) is configured to perform a programming operation of the first memory word (MW, MW1, MW2), the programming operation comprising:
simultaneously resetting all the memory cells of the first memory word; and
simultaneously setting selected memory cells of the first memory word.

12. The memory circuit of claim 1 to 11, configured to perform a forming operation comprising:
simultaneously setting the selection transistors (ST) of the memory circuit in a conducting state to link the first electrode (BE) of the variable resistors (VR) of the memory circuit to the ground of the memory circuit; and
setting the second electrode (TE) of the variable resistors to a positive forming voltage (FMV).

## Patentansprüche

1. Speicherschaltung, umfassend ein erstes Speicherwort (MW), umfassend:
eine Vielzahl von variablen Widerständen, wobei jeder variable Widerstand (VR) eine Speicherzelle ausbildet und eine erste Elektrode (BE) und eine zweite Elektrode (TE) aufweist, die mit einer Bitleitungssteuerschaltung (BLDV) verbunden sind; und
einen ersten Auswahltransistor (ST, ST1), umfassend einen ersten Leitungsanschluss, der mit der ersten Elektrode (BE) jedes variablen Widerstands des ersten Speicherworts, eines zweiten Leitungsanschlusses (SL) und eines Steueranschlusses verbunden ist, der mit einer Wortleitungssteuerschaltung (WLDV) verbunden ist,
wobei:
der zweite Leitungsanschluss (SL) des ersten Auswahltransistors (ST, ST1) mit einer Masse der Speicherschaltung verbunden ist, und
jede Bitleitungssteuerschaltung konfiguriert ist, um die zweite Elektrode (TE) eines der variablen Widerstände auf eine hohe positive Spannung (STV), um die entsprechende Speicherzelle einzustellen, auf eine hohe negative Spannung (RSV), um die entsprechende Speicherzelle zurückzusetzen, und auf eine Lesespannung einzustellen, um zu erfassen, ob die entsprechende Speicherzelle eingestellt oder zurückgesetzt ist.

2. Speicherschaltung nach Anspruch 1, wobei jede Bitleitungssteuerschaltung (BLDV) ferner konfiguriert ist, um die zweite Elektrode (TE) eines der variablen Widerstände (VR) auf eine Ausbildungsspannung einzustellen, um die entsprechende Speicherzelle aus einem fabrikneuen Zustand einzustellen.

3. Speicherschaltung nach Anspruch 1 oder 2, umfassend einen zweiten Auswahltransistor (ST2), umfassend einen ersten Leitungsanschluss, der mit einem zweiten Speicherwort (MW2) verbunden ist, das durch eine andere Vielzahl von variablen Widerständen (VR) der Speicherschaltung ausgebildet wird, und einen zweiten Leitungsanschluss, der mit der Masse der Speicherschaltung verbunden ist, und einen Steueranschluss, der mit dem Steueranschluss des ersten Auswahltransistors (ST1) verbunden ist.

4. Speicherschaltung nach einem der Ansprüche 1 bis 3, umfassend eine Vielzahl von Speicherwörtern (MW), die in Zeilen und Spalten angeordnet ist, jedes Speicherwort umfassend:
eine Vielzahl von variablen Widerständen (VR), die jeweils eine Speicherzelle des Speicherworts ausbilden, und
einen Auswahltransistor (ST), der einen ersten Leitungsanschluss, der mit der ersten Elektrode (BE) jedes des variablen Widerstands des Speicherworts verbunden ist, einen zweiten Leitungsanschluss, der mit der Masse der Speicherschaltung verbunden ist, und einen Steueranschluss aufweist, der mit einer Wortleitungstreiberschaltung (WLDC) durch eine Wortleitung (WL0-WL3)) verbunden ist,
wobei die Steueranschlüsse der Auswahltransistoren aller Speicherwörter, die in einer gleichen Zeile angeordnet sind, mit einer gleichen Wortleitung (WL0-WL3) verbunden sind und alle Speicherwörter, die in einer gleichen Spalte angeordnet sind, mit einer gleichen Gruppe von Bitleitungen ((BL0-BLx-1, BLx-BL2x-1) verbunden sind.

5. Speicherschaltung nach Anspruch 4, wobei die zweiten Leitungsanschlüsse der Auswahltransistoren (ST) von Paaren angrenzender Reihen von Speicherwörtern mit einer gemeinsamen Masseleitung (SL) der Speicherschaltung verbunden sind.

6. Speicherschaltung nach Anspruch 1 bis 5, umfassend eine Spannungsgenerierungsschaltung, die konfiguriert ist, um die hohe positive Spannung (STV) in Form eines Signals eines positiven Impulses (PS1) und die hohe negative Spannung (RSV) in Form eines Signals eines negativen Impulses (PS2) zu generieren, wobei die Signale des positiven und des negativen Impulses der Bitleitungssteuerschaltung (BLDV) bereitgestellt werden, wobei sich das Signal des positiven Impulses zwischen einer Massespannung und der Hochspannung (STV) erstreckt und sich das Signal des negativen Impulses zwischen der Massespannung und der hohen negativen Spannung (RSV) erstreckt.

7. Speicherschaltung nach Anspruch 6, wobei die Spannungsgenerierungsschaltung umfasst:
einen Impulsgenerator (PLG), der konfiguriert ist, um das Signal des positives Impulses (PS1) zu generieren; und
einen Generator negativer Spannung (NVG), der das Signal des positiven Impulses empfängt und konfiguriert ist, um das Signal des negative Impulses (PS2) aus dem Signal des positiven Impulses zu generieren.

8. Speicherschaltung nach Anspruch 1 bis 7, wobei jeder der variablen Widerstände (VR) der Speicherschaltung einen Zustand eines hohen Widerstands, wenn die entsprechende Speicherzelle zurückgesetzt wird, und einen Zustand eines niedrigen Widerstands aufweist, wenn die entsprechende Speicherzelle eingestellt ist, wobei die Bitleitungssteuerschaltung (BLDV) konfiguriert ist, um zu bestimmen, ob einer der variablen Widerstände (VR) in dem Zustand des hohen oder niedrigen Widerstands liegt.

9. Speicherschaltung nach Anspruch 8, wobei, um einen der variablen Widerstände (VR) einzustellen, die Bitleitungssteuerschaltung (BLDV) konfiguriert ist zum:
Zuführen der hohen positiven Spannung (STV) an die zweite Elektrode (TE) des variablen Widerstands;
Erfassen, wenn der variable Widerstand den Zustand des niedrigen Widerstands erreicht; und
Stoppen des Zuführens der hohen positiven Spannung an die zweite Elektrode (TE) des variablen Widerstands, wenn der variable Widerstand in dem Zustand des niedrigen Widerstands erfasst wird.

10. Speicherschaltung nach Anspruch 8 oder 9, wobei, um einen der variablen Widerstände (VR) zurückzusetzen, die Bitleitungssteuerschaltung (BLDV) konfiguriert ist zum:
Zuführen der hohen negativen Spannung (RSV) an die zweite Elektrode (TE) des variablen Widerstands;
Erfassen, wenn der variable Widerstand einen Zustand des hohen Widerstands erreicht; und
Stoppen des Zuführens der hohen negativen Spannung an die zweite Elektrode des variablen Widerstands, wenn der variable Widerstand in dem Zustand des hohen Widerstands erfasst wird.

11. Speicherschaltung nach einem der Ansprüche 1 bis 10, wobei die Bitleitungssteuerschaltung (BLDV) konfiguriert ist, um einen Programmiervorgang des ersten Speicherworts (MW, MW1, MW2) durchzuführen, der Programmiervorgang umfassend:
gleichzeitiges Zurücksetzen aller Speicherzellen des ersten Speicherworts; und
gleichzeitiges Einstellen ausgewählter Speicherzellen des ersten Speicherworts.

12. Speicherschaltung nach Anspruch 1 bis 11, die konfiguriert ist, um einen Ausbildungsvorgang durchzuführen, umfassend:
gleichzeitiges Einstellen der Auswahltransistoren (ST) der Speicherschaltung in einem leitenden Zustand, um die erste Elektrode (BE) der variablen Widerstände (VR) der Speicherschaltung mit der Masse der Speicherschaltung zu verbinden; und
Einstellen der zweiten Elektrode (TE) der variablen Widerstände auf eine positive Ausbildungsspannung (FMV).

## Revendications

1. Circuit mémoire comprenant un premier mot mémoire (MW) comprenant :
une pluralité de résistances variables, chaque résistance variable (VR) formant une cellule mémoire et ayant une première borne (BE) et une seconde borne (TE) connectées à un circuit de commande de ligne de bits (BLDV) ; et
un premier transistor de sélection (ST, ST1) comprenant une première borne de conduction connectée à la première borne (BE) de chaque résistance variable du premier mot mémoire, une deuxième borne de conduction (SL) et une borne de commande connectée à un circuit de commande de ligne de mot (WLDV),
dans lequel :
la deuxième borne de conduction (SL) du premier transistor de sélection (ST, ST1) est connectée à une masse du circuit mémoire, et
chaque circuit de commande de ligne de bits est configuré pour placer la deuxième borne (TE) de l'une des résistances variables à une tension positive élevée (STV) pour activer la cellule mémoire correspondante, à une tension négative élevée (RSV) pour désactiver la cellule mémoire correspondante, et à une tension de lecture pour détecter si la cellule mémoire correspondante est activée ou désactivée.

2. Circuit mémoire selon la revendication 1, dans lequel chaque circuit de commande de ligne de bits (BLDV) est en outre configuré pour régler la deuxième borne (TE) de l'une des résistances variables (VR) sur une tension de formation afin de mettre la cellule mémoire correspondante hors d'un état vierge.

3. Circuit mémoire selon la revendication 1 ou 2, comprenant un deuxième transistor de sélection (ST2) comprenant une première borne de conduction connectée à un deuxième mot mémoire (MW2) formé par une autre pluralité de résistances variables (VR) du circuit mémoire, et une deuxième borne de conduction connectée à la masse du circuit mémoire, et une borne de commande connectée à la borne de commande du premier transistor de sélection (ST1).

4. Circuit mémoire selon l'une des revendications 1 à 3, comprenant une pluralité de mots mémoire (MW), disposés en lignes et en colonnes, chaque mot mémoire comprenant :
une pluralité de résistances variables (VR) formant chacune une cellule mémoire du mot mémoire, et
un transistor de sélection (ST) ayant une première borne de conduction connectée à la première borne (BE) de chacune des résistances variables du mot mémoire, une seconde borne de conduction connectée à la masse du circuit mémoire, et une borne de commande reliée à un circuit de commande de ligne de mot (WLDC) par une ligne de mot (WL0-WL3)),
dans lequel les bornes de commande des transistors de sélection de tous les mots mémoire disposés sur une même ligne sont connectées à une même ligne de mot (WL0-WL3), et tous les mots mémoire disposés sur une même colonne sont connectés à un même groupe de lignes de bits ((BL0 - BLx-1, BLx - BL2x-1).

5. Circuit mémoire selon la revendication 4, dans lequel les deuxièmes bornes de conduction des transistors de sélection (ST) des paires de rangées adjacentes de mots mémoire sont connectées à une ligne de masse commune (SL) du circuit mémoire.

6. Circuit mémoire selon l'une des revendications 1 à 5, comprenant un circuit de génération de tension configuré pour générer la haute tension positive (STV) sous la forme d'un signal d'impulsion positif (PS1) et la haute tension négative (RSV) sous la forme d'un signal d'impulsion négatif (PS2), les signaux d'impulsion positifs et négatifs étant fournis au circuit de commande de la ligne de bits (BLDV), le signal d'impulsion positif évoluant entre une tension de masse et la haute tension (STV), et le signal d'impulsion négatif évoluant entre la tension de masse et la haute tension négative (RSV).

7. Circuit mémoire selon la revendication 6, dans lequel le circuit de génération de tension comprend :
un générateur d'impulsions (PLG) configuré pour générer le signal d'impulsion positif (PS1) ; et
un générateur de tension négative (NVG) recevant le signal d'impulsion positif et configuré pour générer le signal d'impulsion négatif (PS2) à partir du signal d'impulsion positif.

8. Circuit mémoire selon l'une des revendications 1 à 7, dans lequel chacune des résistances variables (VR) du circuit mémoire a un état de résistance élevée lorsque la cellule mémoire correspondante est désactivée, et un état de résistance faible lorsque la cellule mémoire correspondante est activée, le circuit de commande de ligne de bits (BLDV) étant configuré pour déterminer si l'une des résistances variables (VR) est dans l'état de résistance élevée ou faible.

9. Circuit mémoire selon la revendication 8, dans lequel, pour régler l'une des résistances variables (VR), le circuit de commande de ligne de bits (BLDV) est configuré pour :
fournir la haute tension positive (STV) à la deuxième borne (TE) de la résistance variable ;
détecter le moment où la résistance variable atteint l'état de faible résistance ; et
arrêter de fournir la haute tension positive à la deuxième borne (TE) de la résistance variable lorsque la résistance variable est détectée dans l'état de faible résistance.

10. Circuit mémoire selon la revendication 8 ou 9, dans lequel, pour désactiver l'une des résistances variables (VR), le circuit de commande de ligne de bits (BLDV) est configuré pour :
fournir la haute tension négative (RSV) à la deuxième borne (TE) de la résistance variable ;
détecter le moment où la résistance variable atteint un état de haute résistance ; et
arrêter de fournir la haute tension négative à la seconde borne de la résistance variable lorsque la résistance variable est détectée dans l'état de haute résistance.

11. Circuit mémoire selon l'une des revendications 1 à 10, dans lequel le circuit de commande de ligne de bits (BLDV) est configuré pour effectuer une opération de programmation du premier mot mémoire (MW, MW1, MW2), l'opération de programmation comprenant :
désactiver simultanément toutes les cellules mémoire du premier mot mémoire ; et
activer simultanément des cellules mémoire sélectionnées du premier mot mémoire.

12. Circuit mémoire selon l'une des revendications 1 à 11, configuré pour effectuer une opération de formage comprenant les étapes consistant à :
placer simultanément les transistors de sélection (ST) du circuit mémoire dans un état conducteur pour relier la première borne (BE) des résistances variables (VR) du circuit mémoire à la masse du circuit mémoire ; et
régler la deuxième borne (TE) des résistances variables à une tension de formation positive (FMV).
